(19) Europäisches Patentamt
European Patent Office
Office européen des brevets

(11) **EP 4 592 690 A1**

(12) **EUROPEAN PATENT APPLICATION**

(43) Date of publication:
**30.07.2025 Bulletin 2025/31**

(51) International Patent Classification (IPC):
**G01R 27/26** (2006.01) **G01R 31/64** (2020.01)

(21) Application number: **24154050.9**

(52) Cooperative Patent Classification (CPC):
**G01R 31/64; G01R 27/2605**

(22) Date of filing: **25.01.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **LI, Haoran**
**32427 Minden (DE)**

• **KEUL, Thomas**
**63579 Freigericht (DE)**
• **SHI, Huan**
**Shangcheng District, Hangzhou, 310000 (CN)**
• **QU, Yvan-Yongfei**
**Hangzhou, 311201 (CN)**
• **POOK, Stefan**
**32423 Minden (DE)**

(74) Representative: **Maiwald GmbH**
**Engineering**
**Elisenhof**
**Elisenstrasse 3**
**80335 München (DE)**

(54) **CAPACITOR HEALTH DIAGNOSTICS**

(57)   There is provided capacitor health diagnostics circuitry configured to run a diagnostics test to determine the capacity of the at least one buffer capacitor. The diagnostics test comprises a multiphase discharge test performed under varying current conditions to determine a leakage current of the at least one capacitor and to determine the capacitance of the at least one capacitor based at least partially on the determined leakage current.

Fig. 2

EP 4 592 690 A1

## Description

## FIELD OF THE INVENTION

The invention relates to capacitor health diagnostics circuitry and methods.

## BACKGROUND

In the field of industrial process automation, controllers are typically provided with power down functionality which is operable to retain process values measured immediately prior to power failure for reuse upon power up. One example involves a conveyor belt which loads a ship with bulk material. Upon restart after power failure, the control application should continue with exactly the same value of load count as before the power failure. As process control systems increase in complexity, the challenge of implementing power down functionality in a cost effective manner becomes more challenging.

## SUMMARY

To better address one or more of these concerns, there is provided, in a first aspect of invention, capacitor health diagnostics circuitry configured to determine the health status of at least one buffer capacitor. In particular, the capacitor health diagnostics circuitry is operable to run a diagnostics test to determine the capacity of the at least one buffer capacitor. The diagnostics test comprises a multiphase discharge test performed under varying current conditions to determine a leakage current of the at least one capacitor and to determine the capacitance of the at least one capacitor based at least partially on the determined leakage current.

More particularly, the diagnostics test may comprise, in a first phase, performing a first-phase discharge test to determine a first-phase discharge time and, in a second phase, performing a second-phase discharge test to determine a second-phase discharge time, wherein each of the first and second discharge times is measured with respect to a predetermined voltage difference across the capacitor. The at least one capacitor is discharged in the second phase in parallel with a predefined constant current and discharged in the first phase without the predefined constant current, to implement the varying current conditions. The capacitor health diagnostics circuitry is configured to determine the leakage current of the at least one capacitor based on the first and second discharge times and on the predefined constant current.

The discharge tests may be performed using at least one timer which forms part of the device to be powered by the at least one capacitor, e.g., a controller of a process control system. For cost-effectiveness, the timer may be an internal timer of a component which forms part of the device for a purpose other than capacitor health diagnostics. In one example, the timer is the internal timer or counter of logic circuitry which executes a control application for process control in an industrial automation system, or which supports said execution of the control application. Such counters provide high resolution at low cost, so that the capacitor health diagnostics circuitry can be implemented in a cost-effective manner.

The predetermined voltage difference used in the discharge tests may correspond to a difference between a default voltage applied to the at least one capacitor and a predefined setpoint. In the case that the capacitor health diagnostics circuitry comprises a boost converter to convert an input voltage into the default voltage, the predefined setpoint may conveniently be based on an internal reference voltage of an error amplifier in the boost converter.

By performing the multiphase discharge test under varying current conditions, errors caused by inaccuracies of one or more components may cancel one another out when determining the leakage current.

The capacitor health diagnostics circuitry may be further configured to issue a warning when insufficient capacity remains for carrying out a power down sequence. The capacitor health diagnostics circuitry may be further configured to issue a prewarning when the determined capacitance falls under a predetermined threshold. The capacitor health diagnostics circuitry may be further configured to predict when maintenance should be performed, based at least partially on the determined capacitance.

The capacitor health diagnostics circuitry may be further configured to predict aging of the at least one capacitor bank based on historical data relating to previously performed power down sequences.

The capacitor health diagnostics circuitry may be further configured to perform the multiphase discharge using changes of capacitor voltage in a voltage range above a predetermined capacitor voltage required for carrying out a power down sequence. In this way, capacitor health diagnostics can be performed during normal operation, without impairing the power down functionality.

According to a second aspect, there is provided a controller for a process control system, the controller comprising the capacitor health diagnostics circuitry of the first aspect. The controller may be configured to execute a control application for controlling an industrial process. In one example, logic circuitry of the capacitor health diagnostics circuitry may be implemented by the same logic circuitry which executes the control application. The control application may generate process data which may be obtained or extracted by the controller for retention upon power failure. The controller may be configured to store process data in non-volatile storage for a predetermined amount of time, for example at minimum for one hour after power failure. The controller may frequently update the process data to be retained during normal operation until power failure. For example, the controller may periodically place the process data to be retained in static/dynamic RAM, which has an infinitive number of writing cycles and a fast access time, before writing the process data into non-volatile storage (such as F-RAM, M-RAM or nvSRAM) upon power down.

According to a third aspect, there is provided a process control system comprising the capacitor health diagnostics circuitry of the first aspect and/or the controller of the second aspect.

According to a fourth aspect, there is provided an industrial automation system comprising the capacitor health diagnostics circuitry of the first aspect and/or the controller of the second aspect and/or the process control system of the third aspect.

According to a fifth aspect, there is provided a capacitor health diagnostics method. configured to determine the health status of at least one buffer capacitor. The method comprises running a diagnostics test to determine the capacity of the at least one buffer capacitor. The diagnostics test comprises a multiphase discharge test performed under varying current conditions to determine a leakage current of the at least one capacitor and to determine the capacitance of the at least one capacitor based at least partially on the determined leakage current.

The method of the fifth aspect may be computer implemented. Optional features of the first aspect may form part of any of the second-fifth aspects, mutatis mutandis.

According to a sixth aspect, there is provided a computing system configured to perform the method of the fifth aspect.

According to a seventh aspect, there is provided a computer program (product) comprising instructions which, when executed by a computing system, enable or cause the computing system to perform the method of the fifth aspect.

According to an eighth aspect, there is provided a computer-readable (storage) medium comprising instructions which, when executed by a computing system, enable or cause the computing system to perform the method of the fifth aspect. The computer-readable medium may be transitory or non-transitory, volatile or non-volatile.

By using the at least one capacitor as described herein to power the controller in the event of power failure, no battery is necessary.

It will be understood that the techniques described here are applicable not only to controllers for process control systems but to any device which uses a capacitor as an energy source.

By "(process) automation system" is meant an industrial plant or production plant comprising one or more pipelines, production lines, and/or assembly lines for transforming one or more educts into a product and/or for assembling one or more components into a final product.

The term "obtaining", as used herein, may comprise, for example, receiving from another system, device, or process; receiving via an interaction with a user; loading or retrieving from storage or memory; measuring or capturing using sensors or other data acquisition devices.

The term "determining", as used herein, encompasses a wide variety of actions, and may comprise, for example, calculating, computing, processing, deriving, investigating, looking up (e.g., looking up in a table, a database or another data structure), ascertaining, and the like. Also, "determining" may comprise receiving (e.g., receiving information), accessing (e.g., accessing data in a memory), and the like. Also, "determining" may comprise resolving, selecting, choosing, establishing and the like.

The indefinite article "a" or "an" does not exclude a plurality. In addition, the articles "a" and "an" as used herein should generally be construed to mean "one or more" unless specified otherwise or clear from the context to be directed to a singular form.

Unless specified otherwise, or clear from the context, the phrases "one or more of A, B and C", "at least one of A, B, and C", and "A, B and/or C" as used herein are intended to mean all possible permutations of one or more of the listed items. That is, the phrase "A and/or B" means (A), (B), or (A and B), while the phrase "A, B, and/or C" means (A), (B), (C), (A and B), (A and C), (B and C), or (A, B, and C).

The term "comprising" does not exclude other elements or steps. Furthermore, the terms "comprising", "including", "having" and the like may be used interchangeably herein.

The invention may include one or more aspects, examples or features in isolation or combination whether specifically disclosed in that combination or in isolation. Any optional feature or sub-aspect of one of the above aspects applies as appropriate to any of the other aspects.

The above-described aspects will become apparent from, and elucidated with, reference to the detailed description provided hereinafter.

## BRIEF DESCRIPTION OF THE DRAWINGS

A detailed description will now be given, by way of example only, with reference to the accompanying drawings, in which:-

FIG. 1 illustrates a process control system for controlling an industrial process; and

FIG. 2 illustrates capacitor health diagnostics circuitry according to the present disclosure.

## DETAILED DESCRIPTION

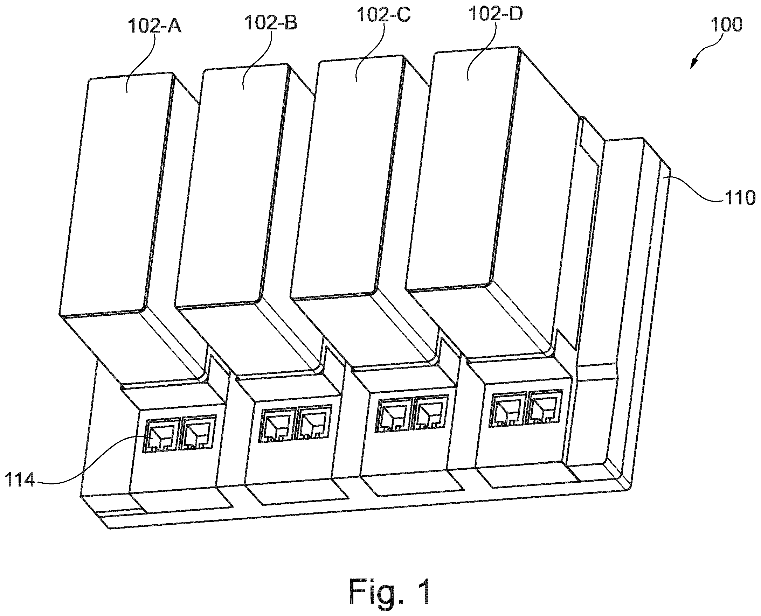

FIG. 1 illustrates a process control system 100 for controlling an industrial process carried out by an automation system (not shown). The process control system 100 comprises multiple controllers 102-A, 102-B, 102-C, 102-D, collectively referred to as controllers 102, which are physically and communicatively coupled to one another via a mounting termination unit (MTU) 110, commonly known as a backplane. The controllers 102 are configured to communicate with other components of the automation system, such as field devices, or an engineering tool as described herein. The engineering tool (typically implemented as a software package) is used to create configuration data for the process control system 100, which can be downloaded to the controllers 102. For the purposes of such communication, the controllers 102 are provided with ethernet ports, such as that illustrated at 114, together with associated communications interface circuitry. Each of the controllers 102 furthermore comprises its own network switch.

Each of the controllers 102 is configured to control a respective process carried out by the automation system (not shown). The process control system 100 may find application in any field of industry where process automation is desired, such as energy, oil and gas, chemical, petrochemical, and so on. The controllers 102 handle process control and monitoring for the automation system by receiving input signals from sensors and instruments, and outputting control signals for controlling plant equipment such as pumps, valves, conveyors, mixers, and heaters. Any such sensor, instrument or plant equipment may form part of one or more of the field devices. The controllers 102 are configured to execute process control applications to generate the control signals on the basis of the input signals. Each control application may comprise control logic instructing the respective controller how to respond to all input signals with appropriate control signals to maintain normal functioning of the process. In one non-limiting example, the control application conforms to the international standard IEC 61131. Each of the controllers 102 comprises logic circuitry configured to execute the respective control application. The logic circuitry may comprise a CPU, MCU, SoC, FPGA, DSP, and/or an AI-engine, together with any memory to be used in the processing of signals. The logic circuitry may be further configured to perform any one or more of the other operations described herein.

One or more of the controllers 102 are furthermore provided with power down functionality which is operable to retain process values measured immediately prior to power failure for reuse upon power up. According to the present disclosure, power down circuitry of the controller 102 comprises at least one buffer capacitor for buffering sufficient energy to complete a power down sequence, together with at least one data storage device (e.g., non-volatile memory) to save application data after detection of power failure by the power down circuitry. The power down sequence comprises the power down circuitry capturing the state of the control application for retention in the data storage device. In one non-limiting example, the power down sequence comprises the following steps: 1) detecting power loss; 2) fetching the control application state data from the control application; 3) storing the control application state data in the data storage device. The power down circuitry may be further configured to perform a power up sequence to resume execution of the control application following restoration of power.

The capacity of the at least one buffer capacitor is important for completion of the power down sequence. During normal operation, the controller is supplied by system power and the at least one capacitor is reverse blocked. In this state, the at least one capacitor is slowly discharged by self-leakage current. Furthermore, aging capacitors suffer loss of capacity and/or higher self-discharge. The loss of capacity endangers completion of the power down sequence. Higher self-discharge leads to additional power dissipation during normal operation.

Therefore, the controller according to the present disclosure comprises capacitor health diagnostics circuitry configured to determine the health status of the at least one buffer capacitor. In particular, the capacitor health diagnostics circuitry runs a diagnostics test to determine the capacity of the at least one buffer capacitor. The diagnostics test may be performed periodically or sporadically, for example during normal operation, to ascertain that sufficient charge remains for satisfactory power down handling. The controller 102 of the present disclosure leverages the internal high-resolution counter which is typically available in even low-cost logic circuitry, such as a microcontroller unit (MCUs) or a system on a chip (SoC), so as to implement the capacitor health diagnostics circuitry in a cost-effective manner.

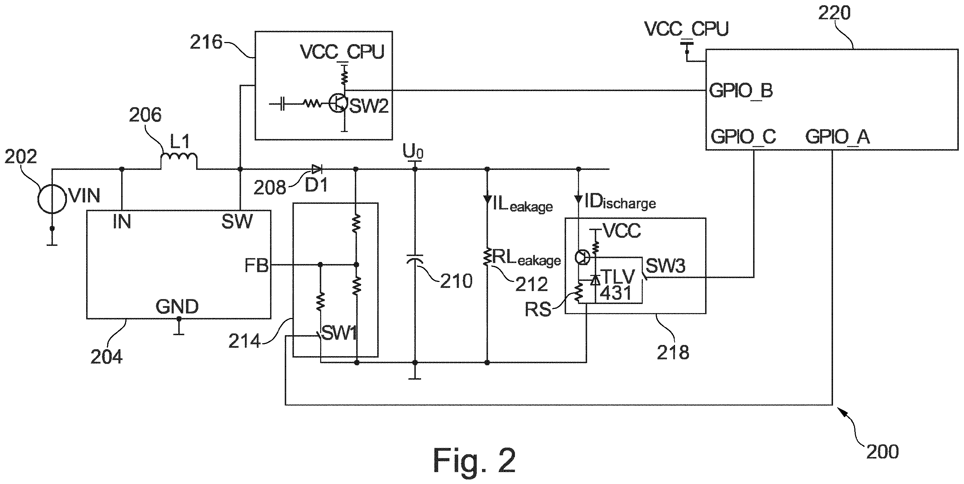

FIG. 2 illustrates capacitor health diagnostics circuitry 200 according to one example. The capacitor health diagnostics circuitry 200 comprises the following elements.

Voltage input 202 provides the input voltage VIN for subsequent circuitry. The input voltage VIN can be direct system input power (e.g. 24V) or an intermediate voltage (e.g. 5.1V).

Step-up/boost function converter 204 (more simply "boost converter") comprises a topology power converter which is operable to generate a boost output voltage Uo that is higher than the input voltage VIN.

Inductance 206 is used by the boost converter 204 to store and release energy during each switching cycle of the converter 204 to assist in generating the boost output voltage.

Reverse block diode 208 prevents current from returning to the voltage input 202.

Capacitor bank 210 provides energy storage for the power down sequence. In one non-limiting example, at least 5 Joules are stored at a default boost voltage of 50V. Any type of capacitor may be used.

Dummy load 212 is used to determine the leakage current $I_{LEAKAGE}$ of the circuitry which is served by the boost voltage Uo.

Voltage feedback network 214 receives a trigger signal at a first switch SW1 to trigger the start of the diagnostics test by causing the voltage feedback network 214 to change the output voltage of the boost converter 204, in the manner described hereinbelow.

Signal detection/decoupling network 216 obtains a switching signal SW from the gate driver signal of the boost converter 204 and drives a second switch SW2 to generate a status signal indicating that discharge is finished and the desired voltage is reached.

Controllable constant current source 218 controls a third switch SW3 during the diagnostic step. The constant current provided by the current source 218 is defined as $I_{Discharge} = Vref / RS$, where Vref is a reference voltage generated for example by the current source 218. Current source 218 is implemented in one non-limiting example using the low-cost voltage reference device TLV431, which is typically accurate to within 1%.

The logic circuitry 220 of the controller 102, as described above, may comprise a CPU, SoC, and/or MCU operable to execute functionality described herein including the diagnostic tests. The logic circuitry 220 furthermore comprises an internal timer function and/or a pulse counting function. The logic circuitry 220 outputs the control signal for the first switch SW1 at general-purpose input/output GPIO_A, receives the status signal from the signal detection/decoupling network 216 at GPIO_B, and outputs a control signal for the third switch SW3 at GPIO_C.

By default, GPIO_A is driven to logic high by the logic circuitry 220 such that the first switch SW1 is on and the output voltage Uo of the boost converter 204 is at the default voltage. The status signal output by the second switch SW2 is ignored by the logic circuitry 220 in this stage. The third switch SW3 is on by virtue of the logic circuitry 220 driving GPIO_C to logic high, such that the current source 218 is disabled. In this state, only leakage current (e.g., a few micro amperes) passes through the transistor of the current source 218.

To start running the diagnostic test for determining the capacity of the capacitor bank 210, the logic circuitry 220 drives GPIO_A to logic low so as to switch the first switch SW1 off. The boost converter 204 detects a voltage increase at its feedback pin FB and stops switching, such that the output voltage Uo decreases in dependence on the leakage current ($I_{LEAKAGE}$) to a lower value, for instance 1V lower than the default voltage. The driver pin SW of the boost converter 204 enters a static state.

The second switch SW2 then delivers a rising edge to the logic circuitry 220 as the status signal. The logic circuitry 220 samples the status signal and records the time which has elapsed since the first switch SW1 was turned off using an internal timer.

When the voltage of the capacitor bank 210 reaches a predefined setpoint, the boost converter 204 restarts switching so as to move the output voltage Uo back towards its default value. The second switch SW2 then delivers a falling edge to the logic circuitry 220, which triggers the logic circuitry 220 to stop the internal timer, record a first-phase discharge time T1, and turn the first switch SW1 back on. In one example, the internal reference voltage used by the control loop amplifier in the boost converter 204 may be used as the setpoint.

According to the present disclosure, the diagnostics test comprises multiple phases.

After the voltage of the capacitor bank 210 returns to the default value, the logic circuitry 220 repeats the first phase as described above but with GPIO_C driven to logic high so as to enable the current source 218 to provide a predefined constant current $I_{Discharge}$. In the second phase, when the voltage of the capacitor bank 210 reaches the setpoint, the boost converter 204 restarts switching and the second swtich SW2 delivers the falling edge to the logic circuitry 220, triggering the logic circuitry 220 to stop the internal timer and record a second-phase discharge time T2.

The first-phase discharge time T1 is affected only by the leakage current $I_{LEAKAGE}$, whereas the second-phase discharge time T2 depends on the leakage current and the discharge current $I_{Discharge}$ provided by the current source 218. Using the two time measurements T1 and T2, first and second measurements of the voltage difference $\Delta Uo$ between the default voltage and the setpoint used by the boost converter 204 are obtained using the following approximations assuming constant currents.

First measurement:

$$\Delta Uo * C = I_{leakage} * T1$$

Second measurement:

$$\Delta Uo * C = (I_{leakage} + I_{Discharge}) * T2$$

Here, C is the total capacitance of the capacitor bank 210, which is assumed to remain constant between the two measurements.

The leakage current can be determined as

$$Ileakage = \frac{IDischarge * T2}{(T1 - T2)}.$$

Therefore, the capacitance C can be determined as

$$C = \frac{ILeakage * T1}{\Delta Uo}.$$

The main sources of error are the inaccuracy (Vref and shunt resistor RS) in the constant current source 218, inaccuracy of the feedback network resistor which is controlled by the first switch SW1, and peak-peak ripple in the output voltage Uo. However, after performing the two-phase measurement process as described herein, such errors can be cancelled out.

The diagnostic test of capacity as described herein may be performed while the capacitor bank 210 is charged with sufficient energy to supply the power down sequence.

The controller 102 may be configured to run further diagnostic tests, for example to check leakage current and to generate an error signal in case the leakage current exceeds one or more thresholds.

If the capacity of the capacitor bank 210 is insufficient to complete the power down sequence, the logic circuitry 220 may issue a warning. One or more pre-warnings may be issued at capacities higher than that needed for the power down sequence. The determined capacity may be used to predict the capacity available for future power down sequences based for example on data relating to capacitor aging, temperature, electrical stress, and/or the behavior of the capacitor bank 210 during historical power down sequences.

The logic circuitry 220 as described herein may be implemented using hardware, software, and/or firmware configured to perform any of the operations described herein. Hardware may comprise one or more processor cores, field-programmable gate arrays (FPGAs), application-specific integrated circuits (ASICs), application-specific standard products (ASSPs), system-on-a-chip systems (SOCs), complex programmable logic devices (CPLDs), etc. Software may be embodied as a software package, code, instructions, instruction sets and/or data recorded on at least one transitory or non-transitory computer readable storage medium. Firmware may be embodied as code, instructions or instruction sets and/or data hard-coded in memory devices (e.g., non-volatile memory devices).

If implemented in software, the functions can be stored on or transmitted over as one or more instructions or code on a computer-readable medium. Computer-readable media include computer-readable storage media. Computer-readable storage media can be any available storage media that can be accessed by a computer. By way of example, and not limitation, such computer-readable storage media can comprise FLASH storage media, RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Disk and disc, as used herein, include compact disc (CD), laser disc, optical disc, digital versatile disc (DVD), floppy disk, and Blu-ray disc (BD), where disks usually reproduce data magnetically and discs usually reproduce data optically with lasers. Further, a propagated signal may be included within the scope of computer-readable storage media. Computer-readable media also includes communications media including any medium that facilitates transfer of a computer program from one place to another. A connection, for instance, can be a communications medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio and microwave are included in the definition of communications medium. Combinations of the above should also be included within the scope of computer-readable media.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features.

It has to be noted that embodiments of the invention are described with reference to different categories. In particular, some examples are described with reference to methods whereas others are described with reference to apparatus. However, a person skilled in the art will gather from the description that, unless otherwise notified, in addition to any combination of features belonging to one category, also any combination between features relating to different category is considered to be disclosed by this application. However, all features can be combined to provide synergetic effects that are more than the simple summation of the features.

While the invention has been illustrated and described in detail in the drawings and foregoing description, such illustration and description are to be considered exemplary and not restrictive. The invention is not limited to the disclosed embodiments. Other variations to the disclosed embodiments can be understood and effected by those skilled in the art, from a study of the drawings, the disclosure, and the appended claims.

The mere fact that certain measures are recited in mutually different dependent claims does not indicate that a combination of these measures cannot be used advantageously.

Any reference signs in the claims should not be construed as limiting the scope.

**Claims**

1. Capacitor health diagnostics circuitry configured to run a diagnostics test to determine the capacity of the at least one buffer capacitor, wherein the diagnostics test comprises a multiphase discharge test performed under varying current conditions to determine a leakage current of the at least one capacitor and to determine the capacitance of the at least one capacitor based at least partially on the determined leakage current.

2. The capacitor health diagnostics circuitry of claim 1, wherein the diagnostics test comprises, in a first phase, performing a first-phase discharge test to determine a first-phase discharge time and, in a second phase, performing a second-phase discharge test to determine a second-phase discharge time, wherein each of the first and second discharge times is measured with respect to a predetermined voltage difference across the capacitor.

3. The capacitor health diagnostics circuitry of claim 2, wherein the at least one capacitor is discharged in the second phase in parallel with a predefined constant current and discharged in the first phase without the predefined constant current, to implement the varying current conditions.

4. The capacitor health diagnostics circuitry of claim 3, configured to determine the leakage current of the at least one capacitor based on the first and second discharge times and on the predefined constant current.

5. The capacitor health diagnostics circuitry of any preceding claim, configured to perform the discharge tests using at least one timer which forms part of a device to be powered by the at least one capacitor.

6. The capacitor health diagnostics circuitry of claim 5, wherein the at least one timer is the internal timer or counter of logic circuitry which executes a control application for process control in an industrial automation system.

7. The capacitor health diagnostics circuitry of any preceding claim, wherein a predetermined voltage difference used in the discharge tests corresponds to a difference between a default voltage applied to the at least one capacitor during normal operation and a predefined setpoint.

8. The capacitor health diagnostics circuitry of claim 7, comprising a boost converter to convert an input voltage into the default voltage, wherein the predefined setpoint is based on an internal reference voltage of a control loop amplifier in the boost converter.

9. The capacitor health diagnostics circuitry of any preceding claim, further configured to issue a warning when insufficient capacity remains for carrying out a power down sequence.

10. The capacitor health diagnostics circuitry of any preceding claim, further configured to predict aging of the at least one capacitor bank based on historical data relating to previously performed power down sequences.

11. The capacitor health diagnostics circuitry of any preceding claim, further configured to perform the multiphase discharge using changes of capacitor voltage in a voltage range above a predetermined capacitor voltage required for carrying out a power down sequence.

12. A controller for a process control system, the controller comprising the capacitor health diagnostics circuitry of any preceding claim.

13. A process control system comprising the capacitor health diagnostics circuitry of any of claims 1-11.

14. A capacitor health diagnostics method comprising running a diagnostics test to determine the capacity of the at least one buffer capacitor, wherein the diagnostics test comprises a multiphase discharge test performed under varying current conditions to determine a leakage current of the at least one capacitor and to determine the capacitance of the at least one capacitor based at least partially on the determined leakage current.

15. A computer-readable medium comprising instructions which, when executed by a computing system, cause the computing system to perform the method of any of claims 1-11.

Fig. 1

EP 4 592 690 A1

Fig. 2

EP 4 592 690 A1

Europäisches
Patentamt

European
Patent Office

Office européen
des brevets

# EUROPEAN SEARCH REPORT

**Application Number**

EP 24 15 4050

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/307939 A1 (JIN SU IL [KR] ET AL) 28 September 2023 (2023-09-28) * paragraph [0057] - paragraph [0124]; claim 1; figures 1-10 * | 1-15 | INV. G01R27/26 G01R31/64 |
| X | US 2021/231720 A1 (BUTLER TIMOTHY SIMON [US] ET AL) 29 July 2021 (2021-07-29) * paragraph [0016] - paragraph [0092]; figures 1-8 * | 1,14,15 | |

**TECHNICAL FIELDS SEARCHED (IPC)**

G01R

The present search report has been drawn up for all claims

| Place of search | Date of completion of the search | Examiner |
|---|---|---|
| Munich | 13 June 2024 | Sedlmaier, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**

EP 24 15 4050

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2024

| Patent document cited in search report | Publication date | Patent family member(s) | Publication date |
|---|---|---|---|
| US 2023307939 A1 | 28-09-2023 | CN 116805497 A | 26-09-2023 |
| | | KR 20230139002 A | 05-10-2023 |
| | | US 2023307939 A1 | 28-09-2023 |
| US 2021231720 A1 | 29-07-2021 | CN 115004504 A | 02-09-2022 |
| | | TW 202146912 A | 16-12-2021 |
| | | US 2021231720 A1 | 29-07-2021 |
| | | US 2023288464 A1 | 14-09-2023 |
| | | WO 2021152439 A1 | 05-08-2021 |

EPO FORM P0459

For more details about this annex : see Official Journal of the European Patent Office, No. 12/82